# EUROPÄISCHE PATENTSCHRIFT

(11) **EP 1 016 229 B1**
(45) Veröffentlichungstag und Bekanntmachung des Hinweises auf die Patenterteilung: **20.03.2002**
(21) Anmeldenummer: 98952526.6
(22) Anmeldetag: 27.08.1998
(51) Int. Cl.: H04B 10/17

(54) **OPTISCHER VERSTÄRKER MIT GEWINNREGELUNG**
OPTICAL AMPLIFIER WITH GAIN ADJUSTMENT
AMPLIFICATEUR OPTIQUE A REGULATION DE GAIN

(30) Priorität: 16.09.1997 DE 19740743
(43) Veröffentlichungstag der Anmeldung: 05.07.2000
(73) Patentinhaber: SIEMENS AKTIENGESELLSCHAFT, 80333 München (DE)
(72) Erfinder: KRUMMRICH, Peter, D-81379 München (DE)
(86) Internationale Anmeldenummer: DE9802539
(87) Internationale Veröffentlichungsnummer: WO9914873

(56) Entgegenhaltungen:
- EP-A- 0 497 491
- EP-A- 0 707 224
- LUO G ET AL: "RELAXATION OSCILLATIONS AND SPECTRAL HOLE BURNING IN LASER AUTOMATIC GAIN CONTROL OF EDFAS" CONFERENCE ON OPTICAL FIBER COMMUNICATIONS, DALLAS, FEB. 16 - 21, 1997,16. Februar 1997, Seite 130/131 XP000776433 INSTITUTE OF ELECTRICAL AND ELECTRONICS ENGINEERS
- JACKEL J L ET AL: "ALL-OPTICAL STABILIZATION OF CASCADED MULTICHANNEL ERBIUM-DOPED FIBER AMPLIFIERS WITH CHANGING NUMBERS OF CHANNELS" CONFERENCE ON OPTICAL FIBER COMMUNICATIONS, DALLAS, FEB. 16 - 21, 1997,16. Februar 1997, Seite 84/85 XP000776416 INSTITUTE OF ELECTRICAL AND ELECTRONICS ENGINEERS

## Beschreibung

Die Erfindung betrifft einen optischen Verstärker nach dem Oberbegriff des Patentanspruchs 1.

Die Übertragung von digitalen Signalen erfolgt bei modernen optischen Übertragungssystemen im Wellenlängen-Multiplexbetrieb. Dieses Verfahren bietet eine Möglichkeit, die Übertragungskapazität zu erhöhen, ohne daß die Bitrate in den einzelnen Übertragungskanälen erhöht werden muß. Dies ergibt erhebliche Vorteile bezüglich der auftretenden Laufzeitverzerrungen (Dispersion) und ermöglicht die Verwendung von weniger aufwendigen Senderschaltungen.

Umrüstungen des Übertragungssystems oder Fehler führen dazu, daß Kanäle zu- oder abgeschaltet werden. Da die optischen Verstärker einer Übertragungsstrecke üblicherweise im Sättigungsbetrieb arbeiten, würde sich ohne zusätzliche Maßnahmen bei einem Ab- oder Zuschalten von Kanälen der Ausgangspegel der in den aktiven Kanälen übertragenen Signale ändern.

In der "Conference on Optical Amplifiers and their Applications", Technical Digest, July 11-13, 1996, Monterey, California, USA; PDP 4-1 bis 4-5 ist eine Regelschaltung beschrieben, die diesem Effekt entgegenwirkt. Ein Detektor mißt den Ausgangspegel und steuert die Pumpleistung.

Eine weitere Möglichkeit zur Verstärkungsregelung ist auf den Seiten FB 2-1 bis FB 2-4 beschrieben. Hier erfolgt eine Klemmung der Inversion (Verstärkung) durch Laseroszillation. Mit Hilfe von als Reflektoren dienenden Fasergittern vor und hinter einem Verstärker wird für eine Wellenlänge innerhalb des übertragenen Wellenlängenspektrums ein longitudinaler Resonator aufgebaut. Durch das Anschwingen einer Laserlinie wird - bei genügend hoher Pumpleistung - der Gewinn konstant gehalten.

Ein Nachteil dieser Lösung besteht darin, daß der Verstärker für die Laserwellenlänge in beiden Richtungen durchlässig sein muß. Diese Bedingung ist nicht ohne weiteres zu erfüllen, wenn der Verstärker optische Isolatoren enthält.

Aus OFC'97 Technical, Seiten 130 und 131 ist ein Verstäker bekannt, dessen Ausgangssignal über einen Wellenlängen-Demultiplexer rückgekoppelt wird, wobei im Rückkopplungsweg ein Bandpaß und ein Dämpfungsglied angeordnet sind. Das rückgekoppelte Signal wird über einen Wellenlängen-Multiplexer mit dem Eingangssignal zusammengefaßt den Verstärkungselementen wieder zugeführt.

Diese Schaltung erfordert die Verwendung mehrerer wellenlängenabhängiger Bauelemente.

In "Electronics Letters", 28th March 1991, Vol. 27, No. 7, Seiten 560 und 561 wird deshalb ein Ringresonator verwendet. Ein Faserkoppler zweigt einen Teil der Ausgangsleistung des Verstärkers ab. Mit Hilfe eines optischen Bandpaßfilters wird ein schmaler Spektralanteil selektiert, in einem Dämpfungsglied abgeschwächt und über einen weiteren Faserkoppler dem Eingang des Verstärkers zugeführt.

Ein Nachteil dieses Verstärkers ist das Auftreten der für die Regelung verwendeten Wellenlänge, der sogenannten Laserlinie, im Ausgangssignal.

Aufgabe der Erfindung ist es, einen Verstärker mit konstantem Gewinn anzugeben, bei dem die Laserlinie im Ausgangssignal nur schwach ausgebildet ist.

Diese Aufgabe wird durch einen optischen Verstärker gemäß Anspruch 1 gelöst. Vorteilhafte Weiterbildungen sind in den Unteransprüchen angegeben.

Durch die Erfindung werden störende Effekte wie durch Nichtlinearitäten in der Übertragungsfaser und im Empfänger bedingtes Übersprechen weitestgehend ausgeschlossen.Die Verstärkung wird für alle unterschiedliche Wellenlängen verwendende Kanäle konstant gehalten. Der Verstärker kann natürlich auch für die Verstärkung nur eines Signals eingesetzt werden.

Bei einem mehrstufigen Verstärker ist es zur Optimierung des Rauschverhaltens vorteilhaft, den Koppler zur Einspeisung des vom Zirkulator ausgekoppelten Lasersignals zwischen der ersten Verstärkerstufe und den zu stabilisierenden Verstärkerstufen einzufügen.

Wenn unterschiedliche Signalbänder verarbeitet werden sollen, ist es zweckmäßig, dem Zirkulator zwei oder mehr Fasergitter nachzuschalten. Die Reflexionswellenlängen der Gitter sind so zu wählen, daß jeweils eine in den Durchlassbereich eines Signalband-Filters fällt. Dadurch wird die vom entsprechenden Fasergitter reflektierte Laserlinie anschwingen. Beim Umschalten auf ein weiteres Signalband-Filter wird dann automatisch die entsprechende von einem anderen Fasergitter reflektierte Laserlinie anschwingen.

Die Erfindung wird anhand von zwei Ausführungsbeispielen näher erläutert.

Es zeigen
- Figur 1: ein Prinzipschaltbild des erfindungsgemäßen Verstärkers und
- Figur 2: einen mehrstufigen Verstärker für unterschiedliche Wellenlängen.

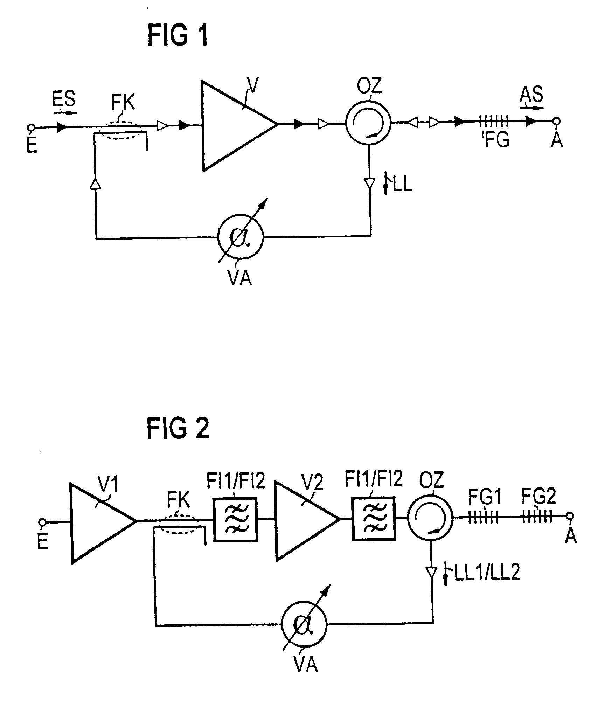

Das in **Figur 1** dargestellte Prinzipschaltbild eines geregelten Verstärkers enthält als Verstärkerelement V einen Faserverstärker oder Halbleiterlaser-Verstärker. An dessen Ausgang ist ein optischer Zirkulator OZ angeschaltet. Der Zirkulator gibt das an einem ersten Eingang anliegende Signal an einen ersten Ausgang weiter und ein an diesem Ausgang eingespeistes Signal an einen zweiten Ausgang ab. Diese Bauelemente können beispielsweise bei der Firma E-TEK DYNAMIKS, INC. bezogen werden.

Als eine spezielle Ausführung des Zirkulators kann auch ein optischer Koppler angesehen werden, der jedoch eine höhere Dämpfung aufweist.

Das Ausgangssignal des Verstärkers wird vom Zirkulator zum Versstärkerausgang A durchgelassen. Zwischen dem Ausgang des optischen Zirkulator für das Verstärkerelement-Ausgangssignal und dem Verstärkerausgang A ist ein in einem sehr engen Wellenbereich reflektierender Reflektor FG eingebaut, der als Fasergitter oder als dielektrisches Filter realisiert ist.

Über einen weiteren Ausgang des optischen Zirkulators wird das reflektierte eine bestimmte Wellenlänge aufweisende schmalbandige Signal, die Laserlinie LL, ausgegeben und über ein variables Dämpfungsglied VA und einen Koppler, hier als Faserkoppler FK realisiert, zusammen mit dem am Verstärkereingang E anliegenden Eingangssignal ES auf den Eingang des Verstärkerelementes V zurückgeführt. Der nicht zum Eingangssignal gehörende rückgeführte Signalanteil, als Laserlinie LL bezeichnet, wird im Ringresonator erzeugt und dient allein zur Regelung der Verstärkung und bestimmt damit auch die Verstärkung innerhalb des zu verarbeitenden Wellenlängenbereiches, den das Eingangssignal ES aufweist. Die Verstärkung wird durch das variable Dämpfungsglied eingestellt. Im Ausgangssignal AS ist die Laserlinie praktisch nicht vorhanden.

Das Nutzsignal und die Laserlinie sind als ausgefüllte und nicht ausgefüllte Pfeilspitzen dargestellt.

Als Verstärkerelement kann ein Faserverstärker verwendet werden, dem dann über weiter Koppler eine entprechende Pumpleistung zugeführt werden muß, wie dies aus dem beschriebenen Stand der Technik bekannt ist. Ebenso kann ein Halbleiterlaser eingesetzt werden.

**Figur 2** zeigt einen zweistufigen Verstärker. Arbeitet die erste Verstärkerstufe V1 im Kleinsignalbetrieb, dann ist eine Stabilisierung ihres Gewinns (Verstärkung) nicht erforderlich. Um einen möglichst rauschfreien Verstärker zu erhalten, ist es vorteilhaft, den Koppler FK zur Einspeisung des rückgeführten Signals zwischen der ersten Verstärkerstufe und den zu stabilisierenden Stufen, hier die Verstärkerstufe V2, einzufügen.

Oft werden optische Bandpaßfilter eingesetzt, die die Übertragung nicht benötigter Wellenlängenbereiche unterdrücken, beispielsweise Anteile der verstärkten spontanen Emission ASE, und nur Signale im gewünschten Wellenlängenbereich durchlassen. Soll der Verstärker nun mehrere Signalbänder verarbeiten können, so muß zwischen verschiedenen Filtern FI1, FI2 umgeschaltet werden. In der Regel ist davon auch die zur Regelung verwendete Laserlinie betroffen, die innerhalb der Signalbänder oder an deren Rändern liegt. Der in Figur 2 dargestellte Verstärker weist deshalb mehrere in Reihe geschaltete Reflektoren auf, die Fasergitter FG1 und FG2. Von den Fasergittern wird jeweils nur eine Wellenlänge reflektiert. Bei Betrieb mit einem ersten Signalband-Filter FI1 wird die vom ersten Fasergitter FG1 reflektierte Laserlinie LL1 anschwingen, beim Umschalten auf ein zweites Signalband-Filter FI2 automatisch die vom zweiten Fasergitter FG2 reflektierte Laserlinie LL2. Die Filter können am Eingang und/oder Ausgang oder im Bereich des Verstärkers angeordnet sein.

Der Verstärker wurde für zwei Signalbänder im Bereich von 1536nn bis 1546nn und von 1548nn bis 1558nn realisiert. Die Signalband-Filter weisen entsprechende Durchlaßbereiche von 1534nn bis 1547nn und 1547nn bis 1560nn auf. Die von den beiden Fasergittern reflektierten Wellenlängen liegen bei 1535nn und bei 1559nn. Der Verstärker wurde für einen Gewinn von 25db mit 2 Verstärkerstufen realisiert.

Es können auch mehrere voneinander unabhängig geregelte Verstärkerstufen in Reihe geschaltet werden.

## Patentansprüche

1. Optischer Verstärker mit Gewinnregelung, der als Ringresonator ausgebildet ist, bei dem zur Verstärkungsregelung vom Verstärkerausgang ein schmalbandiges Signal (LL) über ein Dämpfungsglied (VA) und ein Koppelelement (FK) auf den Eingang eines Verstärkerelementes (V, V2) rückgeführt wird,
**dadurch gekennzeichnet,**
**daß** mit dem zu regelnden Verstärkerelement (V, V2) ein optischer Zirkulator (O2) und mindestens ein schmalbandiger Reflektor (FG, FG1, FG2), der das schmalbandige Signal (LL) reflektiert, in Reihe geschaltet sind und
**daß** der Zirkulator (OZ) einen zweiten mit dem Dämpfungsglied (VA) verbundenen Ausgang für das schmalbandige Signal (LL) aufweist, das auf den Eingang des Verstärkerelementes (V, V2) zurückgeführt wird, dem auch ein Eingangssignal (ES) zugeführt wird.

2. Optischer Verstärker nach Anspruch 1,
**dadurch gekennzeichnet,**
**daß** der Zirkulator (OZ) als optischer Koppler realisiert ist.

3. Optischer Verstärker nach Anspruch 1 oder 2,
**dadurch gekennzeichnet,**
**daß** mehrere Verstärkerstufen (V1, V2) vorgesehen sind.

4. Optischer Verstärker nach Anspruch 3,
**dadurch gekennzeichnet,**
**daß** das rückgeführte schmalbandige Signal (LL) zwischen der ersten Verstärkerstufe (V1) und den zu regelnden Verstärkerstufen (V2) eingekoppelt wird.

5. Optischer Verstärker nach einem der vorhergehenden Ansprüche,
**dadurch gekennzeichnet,**
**daß** optische Filter (FI1, FI2) in den Signalweg eingeschaltet sind.

6. Optischer Verstärker nach Anspruch 5,
**dadurch gekennzeichnet,**
**daß** mehrere optische Reflektoren (FG1, FG2) dem Zirkulator (OZ) nachgeschaltet sind.

7. Optischer Verstärker nach einem der vorhergehenden Ansprüche,
**dadurch gekennzeichnet,**
**daß** als Reflektor (FG) ein Fasergitter vorgesehen ist.

8. Optischer Verstärker nach einem der vorhergehenden Ansprüche,
**dadurch gekennzeichnet,**
**daß** als Verstärkerelement (V, V2) ein Faserverstärker oder ein Halbleiterverstärker vorgesehen ist.

9. Optischer Verstärker nach einem der vorhergehenden Ansprüche,
**dadurch gekennzeichnet,**
**daß** das Dämpfungsglied (VA) zur Verstärkungsänderung einstellbar ist.

10. Optischer Verstärker nach einem der vorhergehenden Ansprüche,
**dadurch gekennzeichnet,**
**daß** er für Wellenlängen-Multipexsignale vorgesehen ist.

## Claims

1. Optical amplifier with gain control, which is designed as a ring resonator, in the case of which, for the purpose of gain control, a narrowband signal (LL) is fed back from the amplifier output via an attenuation element (VA) and a coupling element (FK) to the input of an amplifier element (V, V2),
**characterized**
**in that** an optical circulator (OZ) and at least one narrowband reflector (FG, FG1, FG2), which reflects the narrowband signal (LL) , are connected in series with the amplifier element (V, V2) to be controlled, and
**in that** the circulator (OZ) has a second output, connected to the attenuation element (VA) , for the narrowband signal (LL) which is fed back to the input of the amplifier element (V, V2), to which an input signal (ES) is also fed.

2. Optical amplifier according to Claim 1,
**characterized**
**in that** the circulator (OZ) is realized as an optical coupler.

3. Optical amplifier according to Claim 1 or 2,
**characterized**
**in that** a plurality of amplifier stages (V1, V2) are provided.

4. Optical amplifier according to Claim 3,
**characterized**
**in that** the narrowband signal (LL) that is fed back is coupled in between the first amplifier stage (V1) and the amplifier stages (V2) to be controlled.

5. Optical amplifier according to one of the preceding claims,
**characterized**
**in that** optical filters (FI1, FI1, FI2) are connected into the signal path.

6. Optical amplifier according to Claim 5,
**characterized**
**in that** a plurality of optical reflectors (FG1, FG2) are connected downstream of the circulator (OZ) .

7. Optical amplifier according to one of the preceding claims,
**characterized**
**in that** a fibre grating is provided as the reflector (FG).

8. Optical amplifier according to one of the preceding claims,
**characterized**
**in that** a fibre amplifier or a semiconductor amplifier is provided as the amplifier element (V, V2).

9. Optical amplifier according to one of the preceding claims,
**characterized**
**in that** the attenuation element (V1) is adjustable in order to change the gain.

10. Optical amplifier according to one of the preceding claims,
**characterized**
**in that** it is provided for wavelength division multiplex signals.

## Revendications

1. Amplificateur optique avec régulation de gain qui est conçu comme un résonateur en anneau et dans lequel, pour la régulation d'amplification, un signal à bande étroite (LL) est envoyé en rétroaction de la sortie d'amplificateur à l'entrée d'un élément amplificateur (V, V2) par l'intermédiaire d'un affaiblisseur (VA) et d'un élément de couplage (FK),
**caractérisé par le fait que**
un circulateur optique (OZ) et au moins un réflecteur à bande étroite (FG, FG1, FG2) qui réfléchit le signal à bande étroite (LL) sont branchés en série avec l'élément amplificateur à réguler (V, V2) et
le circulateur (OZ) comporte une deuxième sortie reliée à l'affaiblisseur (VA) pour le signal à bande étroite (LL) qui est renvoyé à l'entrée de l'élément amplificateur (V, V2) auquel est aussi envoyé un signal d'entrée (ES).

2. Amplificateur optique selon la revendication 1,
**caractérisé par le fait que** le circulateur (OZ) est réalisé comme un coupleur optique.

3. Amplificateur optique selon la revendication 1 ou 2,
**caractérisé par le fait que** plusieurs étages amplificateurs (V1, V2) sont prévus.

4. Amplificateur optique selon la revendication 3,
**caractérisé par le fait que** le signal renvoyé à bande étroite (LL) est introduit entre le premier étage amplificateur (V1) et les étages amplificateurs à réguler (V2).

5. Amplificateur optique selon l'une des revendications précédentes,
**caractérisé par le fait que** des filtres optiques (FI1, FI2) sont branchés dans la voie de signal.

6. Amplificateur optique selon la revendication 5,
**caractérisé par le fait que** plusieurs réflecteurs optiques (FG1, FG2) sont branchés du côté aval du circulateur (OZ).

7. Amplificateur optique selon l'une des revendications précédentes,
**caractérisé par le fait qu'**un réseau de fibres est prévu comme réflecteur (FG).

8. Amplificateur optique selon l'une des revendications précédentes,
**caractérisé par le fait qu'**un amplificateur à fibres ou un amplificateur à semi-conducteurs est prévu comme élément amplificateur (V, V2).

9. Amplificateur optique selon l'une des revendications précédentes,
**caractérisé par le fait que** l'affaiblisseur (VA) est réglable pour la modification d'amplification.

10. Amplificateur optique selon l'une des revendications précédentes,
**caractérisé par le fait qu'**il est prévu pour des signaux multiplex en longueurs d'ondes.
